(19) **Europäisches Patentamt / European Patent Office / Office européen des brevets**

(11) **EP 4 773 238 A1**

(12) # EUROPEAN PATENT APPLICATION
published in accordance with Art. 153(4) EPC

(43) Date of publication:
08.07.2026 Bulletin 2026/28

(21) Application number: 24954586.4

(22) Date of filing: 29.11.2024

(51) International Patent Classification (IPC):
$H01M\ 4/505^{(2010.01)}$       $C01B\ 25/45^{(2006.01)}$
$C01B\ 32/05^{(2017.01)}$       $C01G\ 53/44^{(2025.01)}$
$C01G\ 53/504^{(2025.01)}$      $H01M\ 4/525^{(2010.01)}$

(52) Cooperative Patent Classification (CPC):
Y02E 60/10

(86) International application number:
PCT/CN2024/135674

(87) International publication number:
WO 2026/081307 (23.04.2026 Gazette 2026/17)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 15.10.2024 CN 202411442037

(71) Applicant: Eve Power Co., Ltd.
Jingmen, Hubei 448000 (CN)

(72) Inventors:
• ZHAO, Zhenshuai
  Jingmen, Hubei 448000 (CN)
• ZHU, Weihua
  Jingmen, Hubei 448000 (CN)
• HUANG, Chengjie
  Jingmen, Hubei 448000 (CN)
• WEI, Haitao
  Jingmen, Hubei 448000 (CN)

(74) Representative: Zhu, Puxing
Mars Universe IP
c/o Spaces
Mühldorfstraße 8
81671 München (DE)

(54) **POSITIVE ELECTRODE MATERIAL AND PREPARATION METHOD THEREFOR, POSITIVE ELECTRODE SHEET, AND BATTERY**

(57)    The present application provides a positive electrode material, a method for preparing the same, a positive electrode plate, and a battery. The positive electrode material includes a positive electrode active material, which includes a ternary single-crystal material and lithium manganese iron phosphate. The crystal of the ternary single-crystal material has a lattice spacing satisfying the equation of $a_1=b_1$, where the lattice spacing $a_1$ ranges from 2.7 Å to 3.0 Å, and the lattice spacing $c_1$ ranges from 13.5 Å to 15.0 Å. The crystal of lithium manganese iron phosphate has a lattice spacing satisfying the equation of $a_2=b_2$, where the lattice spacing $a_2$ ranges from 6.1 Å to 6.4 Å, and the lattice spacing $c_2$ ranges from 4.6 Å to 5.0 Å.

Mixing a nickel-cobalt-manganese hydroxide precursor, a lithium source, and an additive, and performing sintering to obtain a ternary single-crystal material, where a crystal of the ternary single-crystal material has a lattice spacing of $a_1$ in a first direction, a lattice spacing of $b_1$ in a second direction, and a lattice spacing of $c_1$ in a third direction, where $a_1=b_1$, $a_1$ ranges from 2.7 Å to 3.0 Å, and $c_1$ ranges from 13.5 Å to 15.0 Å; the first direction intersects the second direction, and both the first direction and the second direction are perpendicular to the third direction

↓

Mixing a lithium manganese iron phosphate precursor, a phosphorus-manganese mixed solution, and an alkaline solution, and performing sintering to obtain lithium manganese iron phosphate, where a crystal of the lithium manganese iron phosphate has a lattice spacing of $a_2$ in the first direction, a lattice spacing of $b_2$ in the second direction, and a lattice spacing of $c_2$ in the third direction, where $a_2=b_2$, $a_2$ ranges from 6.1 Å to 6.4 Å, and $c_2$ ranges from 4.6 Å to 5.0 Å

↓

Mixing the ternary single-crystal material and the lithium manganese iron phosphate to obtain a positive electrode active material

↓

Mixing the positive electrode active material, a conductive agent, and a binder to obtain a positive electrode material

FIG. 3

EP 4 773 238 A1

**Description**

This application claims priority to and the benefit of Chinese patent application filed with the China National Intellectual Property Administration on Oct. 15, 2024, with the Application No. 202411442037.X, the disclosure of which is incorporated herein by reference in its entirety.

TECHNICAL FIELD

The present application relates to the field of battery technologies, and in particular, to a positive electrode material, a method for preparing the same, a positive electrode plate, and a battery.

BACKGROUND

As a crucial component of lithium-ion batteries, the choice of positive electrode material directly affects the performance of the battery. Different positive electrode materials have their own advantages and disadvantages due to their structural characteristics. Currently, to balance energy density and safety of the battery, combining ternary materials (NCM) with lithium manganese iron phosphate (LMFP) materials has emerged as a new approach. This method aims to integrate the advantages of both materials, complementing each other's shortcomings, to achieve high-performance batteries with higher energy density and enhanced safety.

SUMMARY

However, ternary materials (NCM) suffer from poor stability, and lithium manganese iron phosphate (LMFP) materials have insufficient conductivity. These drawbacks significantly impact their application in scenarios with special requirements, such as long-range and fast charging.

The present application provides a positive electrode material, a method for preparing the same, a positive electrode plate, and a battery, which can improve the stability and conductivity of the electrode material, thereby enhancing the charging and discharging efficiency of the battery.

In a first aspect, the present application provides a positive electrode material, which includes a positive electrode active material. The positive electrode active material includes a ternary single-crystal material and lithium manganese iron phosphate. A crystal of the ternary single-crystal material has a lattice spacing of $a_1$ in a first direction, a lattice spacing of $b_1$ in a second direction, and a lattice spacing of $c_1$ in a third direction, where $a_1=b_1$, $a_1$ ranges from 2.7 Å to 3.0 Å, and $c_1$ ranges from 13.5 Å to 15.0 Å. A crystal of the lithium manganese iron phosphate has a lattice spacing of $a_2$ in the first direction, a lattice spacing of $b_2$ in the second direction, and a lattice spacing of $c_2$ in the third direction, where $a_2=b_2$, $a_2$ ranges from 6.1 Å to 6.4 Å, and $c_2$ ranges from 4.6 Å to 5.0 Å.

The first direction intersects the second direction, and both the first direction and the second direction are perpendicular to the third direction.

In a second aspect, the present application further provides a method for preparing a positive electrode material, which includes the following steps:

mixing a nickel-cobalt-manganese hydroxide precursor, a lithium source, and an additive, and performing sintering to obtain a ternary single-crystal material, where a crystal of the ternary single-crystal material has a lattice spacing of $a_1$ in a first direction, a lattice spacing of $b_1$ in a second direction, and a lattice spacing of $c_1$ in a third direction, where $a_1=b_1$, $a_1$ ranges from 2.7 Å to 3.0 Å, and $c_1$ ranges from 13.5 Å to 15.0 Å; the first direction intersects the second direction, and both the first direction and the second direction are perpendicular to the third direction;

mixing a lithium manganese iron phosphate precursor, a phosphorus-manganese mixed solution, and an alkaline solution, and performing sintering to obtain lithium manganese iron phosphate, where a crystal of the lithium manganese iron phosphate has a lattice spacing of $a_2$ in the first direction, a lattice spacing of $b_2$ in the second direction, and a lattice spacing of $c_2$ in the third direction, where $a_2=b_2$, $a_2$ ranges from 6.1 Å to 6.4 Å, and $c_2$ ranges from 4.6 Å to 5.0 Å; and

mixing the positive electrode active material, a conductive agent, and a binder to obtain the positive electrode material.

In a third aspect, the present application further provides a positive electrode plate, which includes a positive electrode current collector and the positive electrode material according to the first aspect that is coated on the positive electrode current collector.

In a fourth aspect, the present application further provides a battery, which includes the positive electrode plate according to the third aspect.

BENEFICIAL EFFECTS

The present application provides a positive electrode material, a method for preparing the same, a positive electrode plate, and a battery. The positive electrode material provided in the present application includes a positive electrode active material, which includes a ternary single-crystal material and lithium manganese iron phosphate. A crystal of the ternary single-crystal material has a lattice spacing of $a_1$ in a first direction, a lattice spacing of $b_1$ in a second direction, and a lattice spacing of $c_1$ in a third direction, where $a_1=b_1$, $a_1$ ranges from 2.7 Å to 3.0 Å, and $c_1$ ranges from 13.5 Å to 15.0 Å. A crystal of the lithium manganese iron phosphate has a lattice spacing of $a_2$ in the first direction, a lattice spacing of $b_2$ in the second direction, and a lattice spacing of $c_2$ in the third direction, where $a_2=b_2$, $a_2$ ranges from 6.1 Å to 6.4 Å, and $c_2$ ranges from 4.6 Å to 5.0 Å. The positive electrode active material provided in the present application is formed by mixing the ternary single-crystal material and lithium manganese iron phosphate, with the lattice spacing of both controlled within the aforementioned ranges. This ensures that the positive electrode material has an appropriate lattice spacing, which helps accommodate more ions, enhancing the stability and conductivity of the positive electrode material, thereby improving the charge and discharge efficiency of the battery.

BRIEF DESCRIPTION OF THE DRAWINGS

FIG. 1 is a schematic diagram of a crystal structure of a ternary single-crystal material according to some embodiments of the present application.
FIG. 2 is a schematic diagram of a crystal structure of lithium manganese iron phosphate according to some embodiments of the present application.
FIG. 3 is a flowchart of a method for preparing a positive electrode material according to some embodiments of the present application.

DETAILED DESCRIPTION

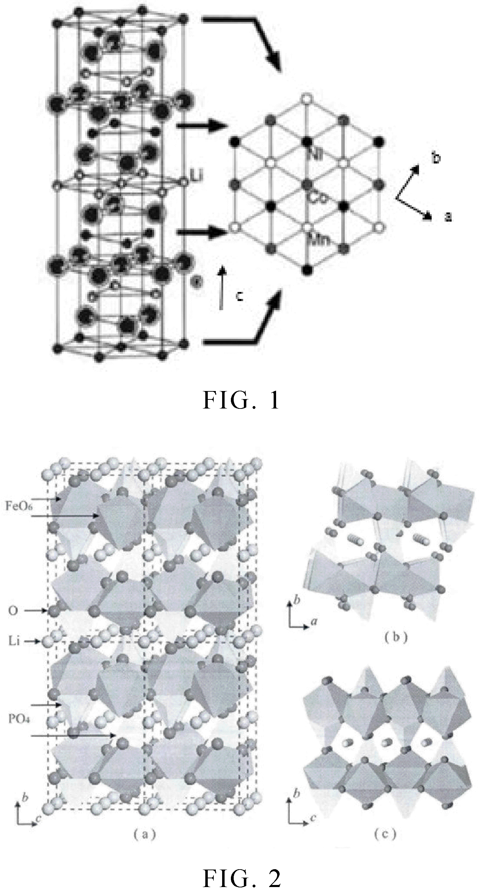

According to the first aspect of the present application, a positive electrode material is provided. The positive electrode material includes a positive electrode active material, which includes a ternary single-crystal material (NCM) and lithium manganese iron phosphate (LMFP). A crystal of the ternary single-crystal material has a lattice spacing of $a_1$ in a first direction, a lattice spacing of $b_1$ in a second direction, and a lattice spacing of $c_1$ in a third direction, where $a_1=b_1$, $a_1$ ranges from 2.7 Å to 3.0 Å, and $c_1$ ranges from 13.5 Å to 15.0 Å. A crystal of the lithium manganese iron phosphate has a lattice spacing of $a_2$ in the first direction, a lattice spacing of $b_2$ in the second direction, and a lattice spacing of $c_2$ in the third direction, where $a_2=b_2$, $a_2$ ranges from 6.1 Å to 6.4 Å, and $c_2$ ranges from 4.6 Å to 5.0 Å. The first direction intersects the second direction, and both the first direction and the second direction are perpendicular to the third direction.
Both the ternary single-crystal material and lithium manganese iron phosphate belong to the hexagonal crystal system. The characteristic symmetry of the hexagonal crystal system determines that the basis vectors corresponding to the unit cell of the hexagonal crystal system have the following features: the two secondary axes (a and b) are perpendicular to the principle axis (c), the magnitudes of the basis vectors of the two secondary axes are equal, and the angle between the secondary axes is 120°. This means the parameters of the unit cell satisfy the following relationships: $a=b \neq c$, $\alpha=\beta=90°$, and $\gamma=120°$.
Please refer to FIG. 1 and FIG. 2. FIG. 1 is a schematic diagram of a crystal structure of a ternary single-crystal material according to some embodiments of the present application. FIG. 2 is a schematic diagram of a crystal structure of lithium manganese iron phosphate according to some embodiments of the present application. In some embodiments of the present application, the crystal structure has a first direction a, a second direction b, and a third direction c. Both the first direction and the second direction are perpendicular to the third direction. $a_1$ represents the lattice spacing of the crystal of the ternary single-crystal material in the direction a, $b_1$ represents the lattice spacing of the crystal of the ternary single-crystal material in the direction b, and $c_1$ represents the lattice spacing of the crystal of the ternary single-crystal material in the direction c (perpendicular to the bottom surface direction), where $a_1=b_1 \neq c_1$. $a_2$ represents the lattice spacing of the crystal of lithium manganese iron phosphate in the direction a, $b_2$ represents the lattice spacing of the crystal of lithium manganese iron phosphate in the direction b, and $c_2$ represents the lattice spacing of the crystal of lithium manganese iron phosphate in the direction c (perpendicular to the bottom surface direction), where $a_2=b_2 \neq c_2$.
During the charge and discharge processes of lithium-ion batteries, the continuous intercalation and deintercalation of lithium ions occur. The performance of the electrode material is crucial for enabling free and stable intercalation and deintercalation of lithium ions, with the lattice size of the electrode material serving as a key parameter for evaluating this capability. If the lattice is too large, the bonding force between atoms weakens, making it prone to deformation under external impact, which affects the stability of the material. Conversely, if the lattice is too small, the distance between atoms decreases, increasing electron scattering and the resistance to ion diffusion, which reduces conductivity. This may increase electrode polarization, leading to a decrease in the charge and discharge efficiency of the battery.

The present application uses a mixture of the ternary single-crystal material and lithium manganese iron phosphate as the positive electrode material. While enhancing the energy density and safety performance of the battery, it addresses the problems of poor stability in ternary single-crystal materials and insufficient conductivity in lithium manganese iron phosphate by controlling their lattice spacings within the specified range.

The ternary single-crystal material and lithium manganese iron phosphate provided in the present application have suitable lattice spacings, which help the electrode material accommodate more ions and enhance structural stability. The appropriate lattice spacing reduces the diffusion resistance of electrons and ions, increases conductivity, and improves the electrochemical performance of the positive electrode material. This enhancement in stability and conductivity of the positive electrode material, in turn, contributes to improving the charge and discharge efficiency of the battery.

In the positive electrode active material provided in the present application, the mass percentage of the ternary single-crystal material is represented with $M_1$, and $M_1$ ranges from 10% to 40%; the mass percentage of lithium manganese iron phosphate is represented with $M_2$, and $M_2$ ranges from 60% to 90%. For example, proportions of the ternary single-crystal material and lithium manganese iron phosphate in the positive electrode active material may be, but are not limited to: the mass percentage of the ternary single-crystal material in the positive electrode active material may be 10%, and the mass percentage of lithium manganese iron phosphate may be 90%. Alternatively, the mass percentage of the ternary single-crystal material in the positive electrode active material may be 20%, and the mass percentage of lithium manganese iron phosphate may be 80%. Alternatively, the mass percentage of the ternary single-crystal material in the positive electrode active material may be 30%, and the mass percentage of lithium manganese iron phosphate may be 70%. Alternatively, the mass percentage of the ternary single-crystal material in the positive electrode active material may be 40%, and the mass percentage of lithium manganese iron phosphate may be 60%. In the positive electrode active material, if the content of the ternary single-crystal material is too low or the content of lithium manganese iron phosphate is too high, it may result in low conductivity of the battery, insufficient rate performance, and an inability to improve kinetics for fast-charging performance. Conversely, if the content of the ternary single-crystal material is too high or the content of lithium manganese iron phosphate is too low, it may lead to insufficient stability of the positive electrode material, making the battery prone to thermal runaway and other problems.

In the present application, the mass percentage $M_1$ of the ternary single-crystal material and the mass percentage $M_2$ of lithium manganese iron phosphate are related to the lattice spacings $a_1$ and $c_1$ of the ternary single-crystal material and the lattice spacings $a_2$ and $c_2$ of lithium manganese iron phosphate. The proportional relationship among $M_1$, $M_2$, $a_1$, $a_2$, $c_1$, and $c_2$ is as follows: $32 < (M_1 * a_1 * c_1) + (M_2 * a_2 * c_2) < 34$. The calculated value according to the proportional relationship $(M_1 * a_1 * c_1) + (M_2 * a_2 * c_2)$ falls within the range of 32 to 34. This ensures that the ternary single-crystal material and lithium manganese iron phosphate in the positive electrode active material have an appropriate mass ratio and suitable lattice sizes, resulting in high conductivity and stability. Additionally, it provides high energy density and safety performance, thereby enabling the battery to achieve high charge and discharge efficiency.

In the present application, the positive electrode material further includes a conductive agent and a binder. The conductive agent is used to improve conductivity of the positive electrode material, and the binder is used to increase adhesion of the positive electrode material. In the positive electrode material, based on a total mass of the positive electrode material being 100%, the mass percentage of the positive electrode active material ranges from 94.5% to 97%, the mass percentage of the conductive agent ranges from 1.5% to 3%, and the mass percentage of the binder ranges from 1.5% to 2.5%. When the content of each component in the positive electrode material falls within these ranges, it exhibits superior electrochemical performance.

The conductive agent may be, but is not limited to, one or more selected from the group consisting of conductive graphite, conductive carbon black, acetylene black, carbon nanotubes, and the like. The binder may be, but is not limited to, one or more selected from the group consisting of styrene-butadiene rubber (SBR), polyacrylic acid (PAA), polyvinylidene fluoride (PVDF), and the like.

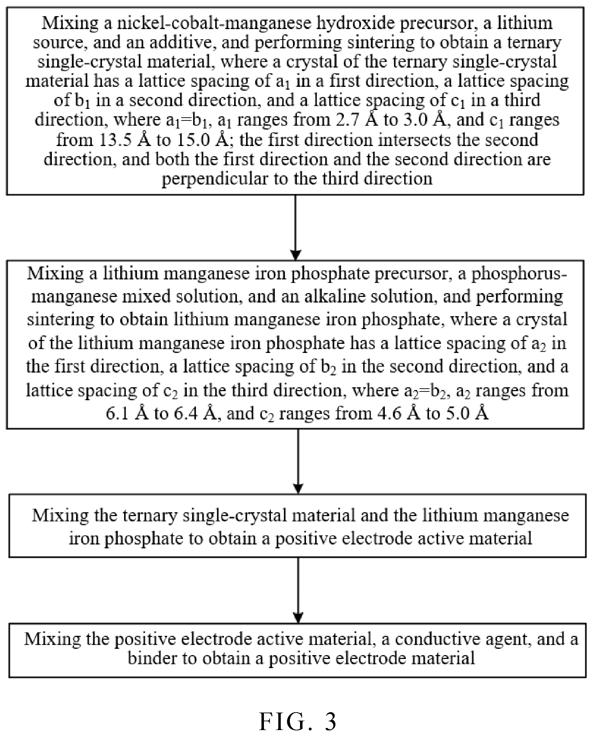

According to the second aspect of the present application, a method for preparing a positive electrode material is provided. Referring to FIG. 3, the method includes the following steps:

mixing a nickel-cobalt-manganese hydroxide precursor, a lithium source, and an additive, and performing sintering to obtain a ternary single-crystal material, where a crystal of the ternary single-crystal material has a lattice spacing of $a_1$ in a first direction, a lattice spacing of $b_1$ in a second direction, and a lattice spacing of $c_1$ in a third direction, where $a_1 = b_1$, $a_1$ ranges from 2.7 Å to 3.0 Å, and $c_1$ ranges from 13.5 Å to 15.0 Å; the first direction intersects the second direction, and both the first direction and the second direction are perpendicular to the third direction;

mixing a lithium manganese iron phosphate precursor, a phosphorus-manganese mixed solution, and an alkaline solution, and performing sintering to obtain lithium manganese iron phosphate, where a crystal of the lithium manganese iron phosphate has a lattice spacing of $a_2$ in the first direction, a lattice spacing of $b_2$ in the second

direction, and a lattice spacing of $c_2$ in the third direction, where $a_2=b_2$, $a_2$ ranges from 6.1 Å to 6.4 Å, and $c_2$ ranges from 4.6 Å to 5.0 Å;

mixing the ternary single-crystal material and the lithium manganese iron phosphate to obtain a positive electrode active material; and

mixing the positive electrode active material, a conductive agent, and a binder to obtain the positive electrode material.

In some embodiments, the method for preparing the positive electrode material includes the following steps.

S1. Preparation of Ternary Single-Crystal Material

Mix the nickel-cobalt-manganese hydroxide precursor, the lithium source, and a first additive, and perform a first sintering to obtain a ternary single-crystal sintered material.

Then, mix the ternary single-crystal sintered material with a second additive, and perform a second sintering to obtain the ternary single-crystal material. The crystal of the ternary single-crystal material has a lattice spacing of $a_1$ in the first direction, a lattice spacing of $b_1$ in the second direction, and a lattice spacing of $c_1$ in the third direction, where $a_1=b_1$, $a_1$ ranges from 2.7 Å to 3.0 Å, and $c_1$ ranges from 13.5 Å to 15.0 Å.

The lithium source may be, but is not limited to, one or more selected from the group consisting of lithium hydroxide, lithium nitrate, lithium acetate, and the like.

The first additive may be, but is not limited to, one or more selected from the group consisting of strontium carbonate, aluminum oxide, zirconium hydroxide, zirconium dioxide, lithium nitrate, magnesium dioxide, niobium oxide, yttrium trioxide, aluminum phosphate, tungsten trioxide, and the like.

The second additive may be, but is not limited to, one or more selected from the group consisting of metal fluorides, lithium compounds, silicates, phosphates, oxides, and the like.

The first sintering is performed at a temperature ranging from 750°C to 900°C for a duration of 20 to 30 hours. The second sintering is performed at a temperature ranging from 400°C to 500°C for a duration of 3 to 10 hours.

After the second sintering, the method further includes the steps of roll pressing, jaw crushing, pulverizing and sieving to obtain the ternary single-crystal material.

S2. Preparation of Lithium Manganese Iron Phosphate

In a liquid-phase system, mix the lithium manganese iron phosphate precursor, the phosphorus-manganese mixed solution, and the alkaline solution. After drying, sinter the mixture under an inert gas atmosphere to obtain lithium manganese iron phosphate. The crystal of the lithium manganese iron phosphate has a lattice spacing of $a_2$ in the first direction, a lattice spacing of $b_2$ in the second direction, and a lattice spacing of $c_2$ in the third direction, where $a_2=b_2$, $a_2$ ranges from 6.1 Å to 6.4 Å, and $c_2$ ranges from 4.6 Å to 5.0 Å.

The drying step includes obtaining the lithium manganese iron phosphate precursor through spray drying.

The sintering is performed under an inert gas atmosphere at a temperature ranging from 750°C to 800°C for a duration of 10 to 15 hours.

The lithium manganese iron phosphate obtained after sintering under an inert gas atmosphere is carbon-coated lithium manganese iron phosphate.

S3. Preparation of Positive Electrode Active Material

Mix the ternary single-crystal material obtained in step S1 with the lithium manganese iron phosphate obtained in step S2 to obtain the positive electrode active material.

The mass percentage of the ternary single-crystal material is represented with $M_1$, ranging from 10% to 40%. The mass percentage of lithium manganese iron phosphate is represented with $M_2$, ranging from 60% to 90%. The proportional relationship among $M_1$, $M_2$, $a_1$, $a_2$, $c_1$, and $c_2$ is as follows: $32<(M_1*a_1*c_1)+(M_2*a_2*c_2)<34$.

S4. Preparation of Positive Electrode Material

Disperse the positive electrode active material obtained in step S3, along with the conductive agent, and the binder, into a solvent and mix to obtain the positive electrode material.

According to the third aspect of the present application, a positive electrode plate is provided. The positive electrode plate includes a positive electrode current collector and the positive electrode material according to the first aspect coated thereon.

In the present application, the material of the positive electrode current collector may be a metal, such as aluminum or copper, but is not limited thereto. A mixed slurry formed from the positive electrode material according to the first aspect is coated onto a surface of the positive electrode current collector, and then dried and calendered to form the positive electrode plate.

The positive electrode current collector may have a sheet-like structure with two opposing surfaces, and the positive electrode material is coated on at least one surface of the positive electrode current collector. For example, the positive electrode material may be coated on one surface of the positive electrode current collector, or on both opposing surfaces thereof. The single-sided areal density coated with the positive electrode material ranges from 210 $g/m^2$ to 230 $g/m^2$. When the single-sided areal density falls within this range, the battery exhibits better endurance. If the areal density is too low, the battery capacity is insufficient, leading to inadequate endurance. If the areal density is too high, it may result in kinetic deficiencies and increased manufacturing costs.

According to the fourth aspect of the present application, a battery is provided. The battery includes a battery casing, and an electrolyte, a negative electrode plate, a separator, and the positive electrode plate according to the third aspect that are located in the battery casing.

The battery casing has an accommodating cavity. The negative electrode plate, the separator, and the positive electrode plate are sequentially stacked in the accommodating cavity. The electrolyte is accommodated in the accommodating cavity. The material of the battery casing may be a metal, such as steel, aluminum, etc.

The negative electrode plate includes a negative electrode current collector and a negative electrode material coated on the negative electrode current collector. The negative electrode material may include graphite, a conductive agent, a binder, and the like. A mixed slurry formed from the negative electrode material is coated onto a surface of the negative electrode current collector, and then dried and calendered to form the negative electrode plate.

The following provides a detailed description of the positive electrode material and battery of the present application through specific examples.

1. Battery Preparation Method

S1. Preparation of Ternary Single-crystal Material

S11: Mix a nickel-cobalt-manganese hydroxide precursor (NCM622), lithium hydroxide, and strontium carbonate. Perform a first sintering at a temperature of 800°C for 24 hours to obtain a ternary single-crystal sintered material.

S12: Mix the ternary single-crystal sintered material obtained in step S11 with $Mn_3O_4$. Perform a second sintering at a temperature of 450°C for 6 hours, followed by roll pressing, jaw crushing, pulverizing, and sieving to obtain the ternary single-crystal material. The crystal of the ternary single-crystal material has a lattice spacing of $a_1$ in the first direction, a lattice spacing of $b_1$ in the second direction, and a lattice spacing of $c_1$ in the third direction, where $a_1=b_1$, $a_1$ ranges from 2.7 Å to 3.0 Å, and $c_1$ ranges from 13.5 Å to 15.0 Å.

S2. Preparation of Lithium Manganese Iron Phosphate

S21: In a liquid-phase system, mix a lithium manganese iron phosphate precursor, a phosphorus-manganese mixed solution, and an alkaline solution, followed by spray drying to obtain a lithium manganese iron phosphate precursor.

S22: Under an Ar gas protective atmosphere, sinter the lithium manganese iron phosphate precursor obtained in step S21 at a temperature of 700°C to obtain lithium manganese iron phosphate, which is carbon-coated lithium manganese iron phosphate. The crystal of the lithium manganese iron phosphate has a lattice spacing of $a_2$ in the first direction, a lattice spacing of $b_2$ in the second direction, and a lattice spacing of $c_2$ in the third direction, where $a_2=b_2$, $a_2$ ranges from 6.1 Å to 6.4 Å, and $c_2$ ranges from 4.6 Å to 5.0 Å.

S3. Preparation of Positive Electrode Active Material

Mix the ternary single-crystal material obtained in step S1 and the lithium manganese iron phosphate obtained in step S2 to obtain the positive electrode active material. The mass percentage of the ternary single-crystal material is represented with $M_1$, ranging from 10% to 40%. The mass percentage of lithium manganese iron phosphate is represented with $M_2$, ranging from 60% to 90%. The proportional relationship among $M_1$, $M_2$, $a_1$, $a_2$, $c_1$, and $c_2$ is as follows:

$$32 < (M_1 * a_1 * c_1) + (M_2 * a_2 * c_2) < 34.$$

S4. Preparation of Positive Electrode Plate

Disperse the positive electrode active material obtained in step S3, along with the conductive agent and binder, into N-methylpyrrolidone (NMP) and mix thoroughly to obtain positive electrode slurry. Coat the positive electrode slurry onto a positive electrode current collector, and after drying and cold pressing, produce the positive electrode plate. The positive electrode current collector is subjected to double-sided coating, with a single-sided areal density ranging from 210 $g/m^2$ to 230 $g/m^2$. The conductive agent includes conductive carbon black (SP) and carbon nanotubes (CNT), the binder includes polyvinylidene fluoride (PVDF), and the mass ratio of the positive electrode active material, the conductive carbon black, the carbon nanotubes, and the polyvinylidene fluoride is 96.5:0.9:0.6:2.

S5. Preparation of Negative Electrode Plate

Disperse the negative electrode material, the conductive agent, and the binder in a solvent, and stir thoroughly to obtain the slurry. Coat the slurry onto the negative electrode current collector, and after drying and cold pressing, produce the negative electrode plate. The negative electrode material is graphite, the conductive agent includes conductive carbon black (SP), the binder includes sodium carboxymethyl cellulose (CMC) and styrene-butadiene rubber (SBR), and the mass ratio of the negative electrode material, the conductive carbon black, sodium carboxymethyl cellulose, and styrene-butadiene rubber is 95.5:2:0.5:2.

S6. Preparation of Battery

Assemble the vacuum-dried positive electrode plate, the separator, and the negative electrode plate, then perform cutting, die-cutting, and slitting processes before placing them into a battery casing. Subsequently, inject the electrolyte under high temperature and negative pressure to assemble a prismatic aluminum shell battery.

Using the above preparation method of the battery, prepare batteries of Example 1 and Comparative Examples 1 to 6. The preparation methods for the negative electrode plate, the negative electrode plate, and the battery in Example 1 and Comparative Examples 1 to 6 are the same, with the difference being the lattice spacing and mass percentage of the ternary single-crystal material and lithium manganese iron phosphate in the positive electrode active material.

Example 1: In the positive electrode plate, the ternary single-crystal material has a lattice spacing $a_1$ of 2.8 Å and $c_1$ of 14 Å; lithium manganese iron phosphate has a lattice spacing $a_2$ of 6.3 Å and $c_2$ of 4.8 Å. The mass percentage of the ternary single-crystal material in the positive electrode active material is 20%, while the mass percentage of lithium manganese iron phosphate is 80%.

Comparative Example 1: In the positive electrode plate, the ternary single-crystal material has a lattice spacing $a_1$ of 2.5 Å and $c_1$ of 13.3 Å; lithium manganese iron phosphate has a lattice spacing $a_2$ of 6.3 Å and $c_2$ of 4.8 Å. The mass percentage of the ternary single-crystal material in the positive electrode active material is 20%, while the mass percentage of lithium manganese iron phosphate is 80%.

Comparative Example 2: In the positive electrode plate, the ternary single-crystal material has a lattice spacing $a_1$ of 3.3 Å and $c_1$ of 15.2 Å; lithium manganese iron phosphate has a lattice spacing $a_2$ of 6.3 Å and $c_2$ of 4.8 Å. The mass percentage of the ternary single-crystal material in the positive electrode active material is 20%, while the mass percentage of lithium manganese iron phosphate is 80%.

Comparative Example 3: In the positive electrode plate, the ternary single-crystal material has a lattice spacing $a_1$ of 2.8 Å and $c_1$ of 14 Å; lithium manganese iron phosphate has a lattice spacing $a_2$ of 5.8 Å and $c_2$ of 4.3 Å. The mass percentage of the ternary single-crystal material in the positive electrode active material is 20%, while the mass percentage of lithium manganese iron phosphate is 80%.

Comparative Example 4: In the positive electrode plate, the ternary single-crystal material has a lattice spacing $a_1$ of 2.8 Å and $c_1$ of 14 Å; lithium manganese iron phosphate has a lattice spacing $a_2$ of 6.7 Å and $c_2$ of 5.1 Å. The mass percentage of the ternary single-crystal material in the positive electrode active material is 20%, while the mass percentage of lithium manganese iron phosphate is 80%.

Comparative Example 5: In the positive electrode plate, the ternary single-crystal material has a lattice spacing $a_1$ of 2.8 Å and $c_1$ of 14 Å; lithium manganese iron phosphate has a lattice spacing $a_2$ of 6.3 Å and $c_2$ of 4.8 Å. The mass percentage of the ternary single-crystal material in the positive electrode active material is 5%, while the mass percentage of lithium manganese iron phosphate is 95%.

Comparative Example 6: In the positive electrode plate, the ternary single-crystal material has a lattice spacing $a_1$ of 2.8 Å and $c_1$ of 14 Å; lithium manganese iron phosphate has a lattice spacing $a_2$ of 6.3 Å and $c_2$ of 4.8 Å. The mass percentage of the ternary single-crystal material in the positive electrode active material is 45%, while the mass percentage of lithium manganese iron phosphate is 55%.

2. Method for Determining Lattice Spacing

The lattice spacing of the aforementioned ternary single-crystal material and lithium manganese iron phosphate is determined using X-ray diffraction (XRD). The steps for determining lattice spacing using the XRD method include:

1) Sample Preparation: Grind the sample into uniform fine particles.

2) Testing Steps: Place the sample on a specific glass slide at an appropriate position on the sample stage. Then set the X-ray wavelength (commonly using a copper Cu target), the scanning range (based on the material's characteristics, covering angles where diffraction peaks may appear), and the scanning speed. Conduct the test and record the data.

3) Data processing: Identify individual diffraction peaks from the obtained diffraction pattern. Based on Bragg's law, $2d\sin\Theta=\eta\lambda$ (where d represents the lattice spacing, $\theta$ represents the diffraction angle, $\eta$ represents the diffraction order, and $\lambda$ represents the X-ray wavelength), and using the known wavelength and diffraction angle, the interplanar spacing d is calculated for a specific diffraction peak (usually high-angle peaks provide more accurate calculations) and its corresponding diffraction order (commonly, simple crystal structures use first-order diffraction ($\eta=1$)).

It should be noted that, as shown in FIG. 1 and FIG. 2, both the ternary single-crystal material and lithium manganese iron phosphate belong to the hexagonal crystal system. In the hexagonal crystal system, the relationships are as follows: $a=b\neq c$, $\alpha=\beta=90°$, and $\gamma=120°$. Here, a and b represent the in-plane lattice spacing, while c represents the interlayer lattice spacing. For the (hkl) crystal plane, such as (100) or (001), the relationship between the interplanar spacing d and the lattice parameters is given by: $1/d^2=4/3(h^2+hk+k^2/a^2)+l^2/c^2$. The values of a, b, and c can be obtained through measurement and calculation.

In the present application, the lattice spacings $a_1$ and $c_1$ of the ternary single-crystal material and the lattice spacings $a_2$ and $c_2$ of lithium manganese iron phosphate were determined using the X-ray diffraction (XRD) method described above. The measurement results are shown in Table 1.

3. Battery Performance Testing

1) Rate Performance Test:

The batteries of Example 1 and Comparative Examples 1 to 6 were calibrated at 25°C with a 1C rate to determine their capacity. After being fully charged, they were discharged at a 2C rate, and the discharge capacity retention rate of each battery was measured. The test results are shown in Table 1.

2) Cycle Performance Test:

The batteries of Example 1 and Comparative Examples 1 to 6 were allowed to stand at 25°C for 1 hour, then charged to 4.2V at a constant current and constant voltage of 1C, with a cutoff current of 0.05C. After standing for 30 minutes, they were discharged to 2.5V at a constant current of 1C. After 500 cycles, the stability of the materials was evaluated based on the cycle capacity retention rate. The test results are shown in Table 1.

3) Thermal Stability Test:

The cells of Example 1 and Comparative Examples 1 to 6 were charged to 100% SOC, then overcharged with a 1C current to trigger thermal runaway. Charging was stopped, and the cells were observed for 1 hour. The test results are shown in Table 1.

Table 1

| | Example 1 | Comparative Example 1 | Comparative Example 2 | Comparative Example 3 | Comparative Example 4 | Comparative Example 5 | Comparative Example 6 |
|---|---|---|---|---|---|---|---|
| Lattice of NCM $a_1$ (Å) | 2.8 | 2.5 | 3.3 | 2.8 | 2.8 | 2.8 | 2.8 |
| Lattice of NCM $c_1$ (Å) | 14 | 13.3 | 15.2 | 14 | 14 | 14 | 14 |
| Mass percentage of NCM M1 (%) | 20 | 20 | 20 | 20 | 20 | 5 | 45 |
| Lattice of LMFP $a_2$ (Å) | 6.3 | 6.3 | 6.3 | 5.8 | 6.7 | 6.3 | 6.3 |
| Lattice of LMFP $c_2$ (Å) | 4.8 | 4.8 | 4.8 | 4.3 | 5.1 | 4.8 | 4.8 |
| Mass percentage of LMFP M2 (%) | 80 | 80 | 80 | 80 | 80 | 95 | 55 |
| Proportional relationship | 32.03 | 30.84 | 34.22 | 27.79 | 35.18 | 30.69 | 34.27 |
| Rate performance (%) | 98.50 | 98.00 | 98.70 | 97.34 | 98.60 | 96.58 | 99.06 |
| Cycle performance (%) | 93.70 | 92.80 | 91.60 | 93.11 | 92.64 | 93.80 | 91.24 |
| Thermal stability (°C) | 208 | 205 | 271 | 128 | 218 | 109 | 407 |

The proportional relationship in Table 1 represents the calculated value of $(M_1{*}a_1{*}c_1)+(M_2{*}a_2{*}c_2)$.

From the data of Example 1 and Comparative Examples 1 to 4, it can be seen that the lattice spacing of NCM and the lattice spacing of LMFP in Example 1 fall within the lattice spacing range specified in the present application. In contrast, the lattice spacing of NCM and/or lattice spacing of LMFP in Comparative Examples 1 to 4 do not fall within this range. Compared to Example 1, the lattice of NCM in Comparative Example 1 is reduced, the lattice of NCM in Comparative Example 2 is increased, the lattice of LMFP in Comparative Example 3 is reduced, and the lattice of LMFP in Comparative Example 4 is increased. From the rate performance and cycle performance data of Comparative Examples 1 to 4, it is evident that when the lattice spacings of Comparative Examples 1 to 4 do not fall within the specified range of the present application, their electrochemical performance deteriorates. The reason is that when the lattice spacing of the positive electrode active material increases, the diffusion resistance for ions and electrons decreases, which improves rate performance. However, the bonding force between atoms weakens, reducing the stability of the material and negatively affecting cycle performance.

From the data of Example 1 and Comparative Examples 5 to 6, it is evident that when the mass percentages of NCM and LMFP do not fall within the specified range in the present application, the overall performance of the lithium-ion battery cannot reach its optimal level. When the content of NCM is too low, the rate performance of the battery is insufficient. Conversely, when the content of NCM is too high, the larger lattice becomes dominant, leading to insufficient stability of the positive electrode material and an increased risk of thermal runaway.

Therefore, when the positive electrode active material includes a ternary single-crystal material and lithium manganese iron phosphate, and the crystal of the ternary single-crystal material has a lattice spacing $a_1$ in the first direction ranging from 2.7 Å to 3.0 Å and a lattice spacing $c_1$ in the third direction ranging from 13.5 Å to 15.0 Å, while the crystal of lithium manganese iron phosphate has a lattice spacing $a_2$ in the first direction ranging from 6.1 Å to 6.4 Å and a lattice spacing $c_2$ in the third direction ranging from 4.6 Å to 5.0 Å, it can effectively enhance the stability and conductivity of the positive electrode material, thereby improving the charge and discharge efficiency of the battery.

**Claims**

1. A positive electrode material, comprising a positive electrode active material, wherein the positive electrode active material comprises a ternary single-crystal material and lithium manganese iron phosphate;

   wherein a crystal of the ternary single-crystal material has a lattice spacing of $a_1$ in a first direction, a lattice spacing of $b_1$ in a second direction, and a lattice spacing of $c_1$ in a third direction, wherein $a_1=b_1$, $a_1$ ranges from 2.7 Å to 3.0 Å, and $c_1$ ranges from 13.5 Å to 15.0 Å;
   wherein a crystal of the lithium manganese iron phosphate has a lattice spacing of $a_2$ in the first direction, a lattice spacing of $b_2$ in the second direction, and a lattice spacing of $c_2$ in the third direction, wherein $a_2=b_2$, $a_2$ ranges from 6.1 Å to 6.4 Å, and $c_2$ ranges from 4.6 Å to 5.0 Å; and
   wherein the first direction intersects the second direction, and both the first direction and the second direction are perpendicular to the third direction.

2. The positive electrode material according to claim 1, wherein in the positive electrode active material, a mass percentage of the ternary single-crystal material is represented with $M_1$, and $M_1$ ranges from 10% to 40%; and wherein a mass percentage of the lithium manganese iron phosphate is represented with $M_2$, and $M_2$ ranges from 60% to 90%.

3. The positive electrode material according to claim 2, wherein a proportional relationship among $M_1$, $M_2$, $a_1$, $a_2$, $c_1$, and $c_2$ is as follows: $32<(M_1{*}a_1{*}c_1)+(M_2{*}a_2{*}c_2)<34$.

4. The positive electrode material according to any one of claims 1 to 3, wherein the positive electrode material further comprises a conductive agent and a binder; wherein in the positive electrode material, a mass percentage of the positive electrode active material ranges from 94.5% to 97%, a mass percentage of the conductive agent ranges from 1.5% to 3%, and a mass percentage of the binder ranges from 1.5% to 2.5%.

5. The positive electrode material according to any one of claims 1 to 3, wherein the lithium manganese iron phosphate is carbon-coated lithium manganese iron phosphate.

6. A method for preparing a positive electrode material, comprising the following steps:

mixing a nickel-cobalt-manganese hydroxide precursor, a lithium source, and an additive, and performing sintering to obtain a ternary single-crystal material, wherein a crystal of the ternary single-crystal material has a lattice spacing of $a_1$ in a first direction, a lattice spacing of $b_1$ in a second direction, and a lattice spacing of $c_1$ in a third direction, wherein $a_1=b_1$, $a_1$ ranges from 2.7 Å to 3.0 Å, and $c_1$ ranges from 13.5 Å to 15.0 Å; the first direction intersects the second direction, and both the first direction and the second direction are perpendicular to the third direction;

mixing a lithium manganese iron phosphate precursor, a phosphorus-manganese mixed solution, and an alkaline solution, and performing sintering to obtain lithium manganese iron phosphate, wherein a crystal of the lithium manganese iron phosphate has a lattice spacing of $a_2$ in the first direction, a lattice spacing of $b_2$ in the second direction, and a lattice spacing of $c_2$ in the third direction, wherein $a_2=b_2$, $a_2$ ranges from 6.1 Å to 6.4 Å, and $c_2$ ranges from 4.6 Å to 5.0 Å;

mixing the ternary single-crystal material and the lithium manganese iron phosphate to obtain a positive electrode active material; and

mixing the positive electrode active material, a conductive agent, and a binder to obtain the positive electrode material.

7. The method for preparing the positive electrode material according to claim 6, wherein the steps of mixing the nickel-cobalt-manganese hydroxide precursor, the lithium source, and the additive, and performing sintering to obtain the ternary single-crystal material comprise:

mixing the nickel-cobalt-manganese hydroxide precursor, the lithium source, and a first additive, and performing a first sintering to obtain a ternary single-crystal sintered material; and

mixing the ternary single-crystal sintered material with a second additive, and performing a second sintering to obtain the ternary single-crystal material; and

wherein the steps of mixing the lithium manganese iron phosphate precursor, the phosphorus-manganese mixed solution, and the alkaline solution, and performing sintering to obtain the lithium manganese iron phosphate comprise:

mixing the lithium manganese iron phosphate precursor, the phosphorus-manganese mixed solution, and the alkaline solution in a liquid-phase system, after drying, performing sintering under an inert gas atmosphere to obtain the lithium manganese iron phosphate, wherein the lithium manganese iron phosphate is carbon-coated lithium manganese iron phosphate.

8. A positive electrode plate, comprising a positive electrode current collector and the positive electrode material as claimed in any one of claims 1 to 5, wherein the positive electrode material is coated on the positive electrode current collector.

9. The positive electrode plate according to claim 8, wherein at least one surface of the positive electrode current collector is coated with the positive electrode material, and a single-sided areal density coated with the positive electrode material ranges from 210 g/m$^2$ to 230 g/m$^2$.

10. A battery, comprising the positive electrode plate as claimed in any one of claims 8 and 9.

FIG. 1

FIG. 2

Mixing a nickel-cobalt-manganese hydroxide precursor, a lithium source, and an additive, and performing sintering to obtain a ternary single-crystal material, where a crystal of the ternary single-crystal material has a lattice spacing of $a_1$ in a first direction, a lattice spacing of $b_1$ in a second direction, and a lattice spacing of $c_1$ in a third direction, where $a_1=b_1$, $a_1$ ranges from 2.7 Å to 3.0 Å, and $c_1$ ranges from 13.5 Å to 15.0 Å; the first direction intersects the second direction, and both the first direction and the second direction are perpendicular to the third direction

Mixing a lithium manganese iron phosphate precursor, a phosphorus-manganese mixed solution, and an alkaline solution, and performing sintering to obtain lithium manganese iron phosphate, where a crystal of the lithium manganese iron phosphate has a lattice spacing of $a_2$ in the first direction, a lattice spacing of $b_2$ in the second direction, and a lattice spacing of $c_2$ in the third direction, where $a_2=b_2$, $a_2$ ranges from 6.1 Å to 6.4 Å, and $c_2$ ranges from 4.6 Å to 5.0 Å

Mixing the ternary single-crystal material and the lithium manganese iron phosphate to obtain a positive electrode active material

Mixing the positive electrode active material, a conductive agent, and a binder to obtain a positive electrode material

FIG. 3

TRANSLATION

## INTERNATIONAL SEARCH REPORT

International application No.

**PCT/CN2024/135674**

| A. | CLASSIFICATION OF SUBJECT MATTER |
|---|---|

H01M 4/505(2010.01)i; C01B25/45(2006.01)i; C01B32/05(2017.01)i; C01G53/44(2025.01)i; C01G53/504(2025.01)i; H01M4/525(2010.01)i

According to International Patent Classification (IPC) or to both national classification and IPC

| B. | FIELDS SEARCHED |
|---|---|

Minimum documentation searched (classification system followed by classification symbols)

IPC:H01M4, C01B25, C01B32, C01G53

Documentation searched other than minimum documentation to the extent that such documents are included in the fields searched

Electronic data base consulted during the international search (name of data base and, where practicable, search terms used)

CNABS, CNTXT, DWPI, Elsevier Science Direct, ISI Web of Science, 读秀, DUXIU, 超星科技数字图书馆, Chao Xing Science and Technology Digital Library: 湖北亿纬动力有限公司, 赵贞帅, 朱伟华, 正极材料, 三元单晶材料, 磷酸铁锰锂, 晶格间距, 六方晶体, anode material, ternary single crystal material, lithium iron manganese phosphate

| C. | DOCUMENTS CONSIDERED TO BE RELEVANT |
|---|---|

| Category* | Citation of document, with indication, where appropriate, of the relevant passages | Relevant to claim No. |
|---|---|---|
| A | CN 115799481 A (EVE ENERGY CO., LTD.) 14 March 2023 (2023-03-14) description, paragraphs 7-27 | 1-10 |
| A | CN 109473675 A (LANGFANG INSTITUTE OF PROCESS ENGINEERING, CAS et al.) 15 March 2019 (2019-03-15) entire document | 1-10 |
| A | CN 114430027 A (BYD CO., LTD.) 03 May 2022 (2022-05-03) entire document | 1-10 |
| A | CN 115172681 A (XI'AN HESHENG HUILI NEW MATERIAL CO., LTD.) 11 October 2022 (2022-10-11) entire document | 1-10 |
| A | JP 2010219065 A (NGK INSULATORS LTD.) 30 September 2010 (2010-09-30) entire document | 1-10 |

☑ Further documents are listed in the continuation of Box C. ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **13 June 2025** | **24 June 2025** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2024/135674**

| C. | DOCUMENTS CONSIDERED TO BE RELEVANT | |
|---|---|---|
| Category* | Citation of document, with indication, where appropriate, of the relevant passages | Relevant to claim No. |
| A | WO 2024103678 A1 (NINGBO RONBAY NEW ENERGY TECHNOLOGY CO., LTD.) 23 May 2024 (2024-05-23) entire document | 1-10 |

Form PCT/ISA/210 (second sheet) (July 2022)

**INTERNATIONAL SEARCH REPORT**
Information on patent family members

International application No.

**PCT/CN2024/135674**

| Patent document cited in search report | | | Publication date (day/month/year) | Patent family member(s) | | | Publication date (day/month/year) |
|---|---|---|---|---|---|---|---|
| CN | 115799481 | A | 14 March 2023 | US | 2023416112 | A1 | 28 December 2023 |
| | | | | WO | 2024130869 | A1 | 27 June 2024 |
| | | | | CN | 115799481 | B | 13 December 2024 |
| CN | 109473675 | A | 15 March 2019 | CN | 109473675 | B | 17 August 2021 |
| CN | 114430027 | A | 03 May 2022 | CN | 114430027 | B | 14 November 2023 |
| CN | 115172681 | A | 11 October 2022 | None | | | |
| JP | 2010219065 | A | 30 September 2010 | None | | | |
| WO | 2024103678 | A1 | 23 May 2024 | CN | 115763733 | A | 23 May 2023 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202411442037X